# FASCICULE DE BREVET EUROPEEN

(11) **EP 3 895 190 B1**
(45) Date de publication et mention de la délivrance du brevet: **25.03.2026**
(21) Numéro de dépôt: 19809870.9
(22) Date de dépôt: 04.12.2019
(51) Int. Cl.: H01G 11/18, H01G 11/82, H01G 2/04, H01G 2/10, H01G 11/08, H01M 10/625, H01M 10/6554, H01M 50/271, H05K 7/14

(54) **ENSEMBLE D'UN BLOC CAPACITIF AVEC ORGANES DE RETENUE INTÉGRÉS**
ANORDNUNG FÜR EINEN KAPAZITIVEN BLOCK MIT INTEGRIERTEN HALTEGLIEDERN
ASSEMBLY FOR A CAPACITIVE BLOCK WITH INTEGRATED RETENTION MEMBERS

(30) Priorité: 14.12.2018 FR 1872982
(43) Date de publication de la demande: 20.10.2021
(73) Titulaire: Valeo Electrification, 95800 Cergy (FR)
(72) Inventeur: MORTAIN, Eloi, 92150 SURESNES (FR); MOCERI, Alwin, 78700 CONFLANS SAINTE-HONORINE (FR)
(74) Mandataire: Valeo Powertrain Systems
(86) Numéro de dépôt international: PCT/EP2019/083614
(87) Numéro de publication internationale: WO 2020/120245

(56) Documents cités:
- EP-A1- 1 589 547
- WO-A1-2005/086189
- WO-A1-2013/102720
- WO-A2-2017/191135
- FR-A1- 2 924 857
- US-A1- 2009 061 301
- US-A1- 2013 105 210

## Description

### DOMAINE TECHNIQUE L'INVENTION

La présente invention concerne un équipement électrique comprenant notamment un bloc capacitif et un couvercle.

La présente invention vise en particulier à faciliter l'assemblage d'un tel ensemble dans un équipement électrique, tel qu'un onduleur, un convertisseur de tension continu-continu ou un chargeur électrique par exemple, notamment dans le domaine des systèmes de motorisation électrique pour véhicule.

L'invention vise notamment à permettre un assemblage adapté à la production en grande série de tels équipements électriques.

### ETAT DE LA TECHNIQUE

Comme cela est connu, dans un véhicule automobile électrique ou hybride, une batterie d'alimentation haute tension assure une fonction d'alimentation en énergie d'un système de motorisation électrique permettant la propulsion du véhicule. Afin d'être chargée, la batterie d'alimentation haute tension est par exemple connectée à un réseau électrique d'alimentation externe, notamment via un chargeur électrique comprenant au moins un convertisseur de tension continu-continu.

Afin de commander la machine électrique entrainant les roues du véhicule, il est connu d'utiliser un onduleur permettant de convertir le courant fourni par la batterie d'alimentation haute tension en un ou plusieurs courants de commande alternatifs, par exemple sinusoïdaux.

L'onduleur comprend un bloc capacitif permettant de lisser le courant fourni par la batterie d'alimentation, avant sa conversion en courants de commande alternatifs. Le bloc capacitif comprend un boîtier comprenant une cavité, dans laquelle est insérée une capacité de lissage. Cette capacité permet ainsi de supprimer les perturbations résiduelles du courant afin que ce courant puisse être converti en courants de commande alternatifs.

L'onduleur comprend en outre un module de puissance configuré pour réaliser la conversion du courant fourni par la batterie en courants alternatifs de commande injectés dans la machine électrique.

Le bloc capacitif comprend également au moins deux connecteurs d'entrée, notamment un connecteur correspondant à la borne négative de la capacité et un connecteur correspondant à la borne positive de la capacité. Ces connecteurs d'entrée permettent ainsi de donner un accès aux bornes négative et positive de la capacité, afin de connecter la capacité au reste du système

Dans un onduleur, le bloc capacitif comprend en outre des connecteurs de sortie généralement agencés en une barre de connexion électrique destinée à être reliée à des connecteurs de phase de la machine électrique.

D'autres équipements électriques, notamment de véhicule électrique ou hybride, tels qu'un convertisseur de tension continu-continu ou un chargeur électrique, peuvent comporter également de tels types de blocs capacitifs.

Comme cela est connu, le bloc capacitif doit être refroidi de manière à dissiper la chaleur émise par la capacité. A cette fin, le bloc capacitif est posé sur un circuit de refroidissement.

En particulier, le bloc capacitif peut être disposé sur un couvercle, et former avec ledit couvercle un ensemble, puis être assemblé sur un châssis. Des exemples de tels types d'ensembles dans l'état de la technique peuvent être trouvés dans les documents EP 1589547 A1, WO 2017/191135 A2, US 2013/105210 et US 2009/061301 A1.

Notamment, dans le contexte d'un processus d'assemblage dans lequel l'ensemble comprenant un bloc capacitif disposé sur un couvercle est amené sur un châssis principal, notamment d'un onduleur fournissant de l'énergie à un moteur électrique, ledit ensemble peut devoir être retourné sans que ledit bloc capacitif n'ait pu être vissé, à ce stade.

Ces nécessités découlent par exemple de difficultés d'accès à des points de vissages des différents éléments de l'ensemble entre eux ou dudit ensemble sur le châssis, compte tenu également des positions requises d'équipements tiers.

Le problème technique concerne ainsi le maintien du bloc capacitif en position disposé sur le couvercle lors de la phase de retournement de cet ensemble en vue de son positionnement sur le châssis principal.

A cette fin, il est proposé de pourvoir le boîtier du bloc capacitif et le couvercle d'organes complémentaires de retenue, sur le boîtier du bloc capacitif et sur le couvercle, lesdits organes complémentaires de retenue étant actifs lors du retournement de l'ensemble correspondant en vue de l'amener sur le carter principal auquel ledit bloc capacitif doit être fixé, notamment de manière à se trouver au contact d'un circuit de refroidissement dudit châssis principal.

### PRESENTATION DE L'INVENTION

La présente invention concerne un ensemble d'un couvercle et d'un bloc capacitif selon la revendication 1, un équipement électrique selon la revendication 7 et un onduleur selon la revendication 8. Les modes de réalisation de l'invention sont décrits dans les revendications dépendantes.

Plus précisément, l'invention a pour objet un ensemble d'un couvercle et d'un bloc capacitif, le bloc capacitif comprenant un boîtier qui comprend au moins un premier organe de retenue, le couvercle comprenant au moins un second organe de retenue complémentaire, le au moins un second organe de retenue comportant une butée de retenue configurée pour recevoir une portion dudit au moins un premier organe de retenue lorsque le bloc capacitif est engagé dans le couvercle, de façon à retenir le bloc capacitif lors d'un retournement de l'ensemble dudit couvercle et dudit bloc capacitif, notamment lors d'une phase d'assemblage dudit ensemble sur un châssis d'un équipement électrique.

Grâce à l'invention, le bloc capacitif est maintenu sur le couvercle lors du retournement de l'ensemble qu'il forme avec ledit couvercle en vue de son assemblage sur le châssis principal.

Selon une forme de réalisation, le au moins un second organe de retenue présente un jeu permettant un degré de liberté en translation du bloc capacitif vis-à-vis du couvercle dans une direction opposée à la butée de retenue.

Selon une forme de réalisation, le au moins un premier organe de retenue comprend au moins un clip de retenue issu de matière du boîtier du bloc capacitif et comprenant une excroissance configurée pour coopérer avec la butée du au moins un second organe de retenue.

Selon une forme de réalisation, le boîtier du bloc capacitif comprend au moins un fût dans lequel s'engage au moins un plot de guidage, pour participer au maintien du bloc capacitif lors du retournement de l'ensemble dudit couvercle et dudit bloc capacitif.

Selon une forme de réalisation, le moins un second organe de retenue comprend au moins une rainure aménagée dans une surface interne d'une paroi latérale du couvercle.

Selon une forme de réalisation, le au moins un second organe de retenue comprend au moins un épaulement aménagé dans la masse d'une surface interne d'une paroi latérale du couvercle.

Selon une forme de réalisation, l'ensemble comprend une plaque ressort positionnée dans le couvercle, le bloc capacitif étant disposé en appui sur ladite plaque ressort.

L'invention vise également un équipement électrique adapté à être mis en œuvre dans un véhicule électrique ou hybride, comprenant un ensemble tel que brièvement décrit ci-dessus.

L'invention vise aussi un onduleur comprenant un châssis comportant un circuit de refroidissement, comprenant un ensemble électrique tel que brièvement décrit ci-dessus, disposé d'un côté du circuit de refroidissement et, disposé de l'autre côté du circuit de refroidissement, un module électronique de puissance.

### PRESENTATION DES FIGURES

L'invention sera mieux comprise à la lecture de la description qui va suivre, en se référant aux dessins annexés donnés à titre d'exemples non limitatifs, dans lesquels des références identiques sont données à des objets semblables et sur lesquels :
Fig. 1 est une vue en perspective d'un bloc capacitif selon un exemple de réalisation de l'invention ;
Fig. 2 est une vue en perspective éclatée d'un équipement électrique comprenant un ensemble d'un couvercle et d'un bloc capacitif, selon un exemple de réalisation de l'invention ;
Fig. 3 est une vue de côté d'un bloc capacitif selon un exemple de réalisation de l'invention ;
Fig. 4 est une vue en perspective d'un couvercle d'un ensemble selon un exemple de réalisation de l'invention ;
Fig. 5 est une vue en perspective d'un ensemble comprenant un couvercle et un bloc capacitif, selon un exemple de réalisation de l'invention.

Il faut noter que les figures exposent l'invention de manière détaillée pour mettre en œuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite dans le contexte d'un équipement électrique destiné à un véhicule, notamment un véhicule automobile électrique ou hybride, sans limiter la portée de la présente invention telle qu'elle est définie dans les revendications annexées.

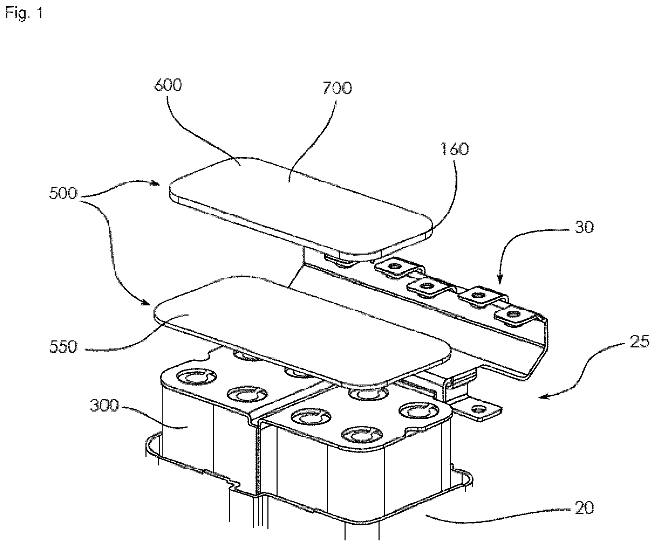

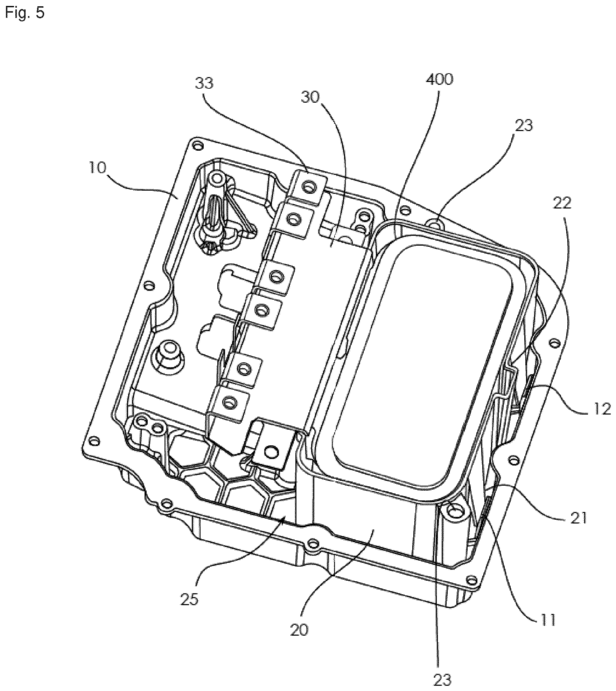

En référence à la figure 1, **il** est partiellement représenté un bloc capacitif 25 selon un exemple de l'invention. Dans ce qui suit, on fait également référence à la figure 5 qui montre un bloc capacitif 25 dans un équipement électrique. Le bloc capacitif 25 comporte un boîtier 20 et un élément capacitif 300, logé dans le boîtier 20, une substance 400 remplissant l'espace entre le boîtier 20 et l'élément capacitif 300 de manière à réaliser une étanchéité de l'élément capacitif 300, et un dissipateur thermique 500 contre lequel l'élément capacitif 300 est en contact direct.

Dans l'exemple représenté, le dissipateur thermique 500 peut comporter une plaque 700 dont une face opposée à l'élément capacitif 300 forme la face libre 600 du dissipateur thermique 500. La plaque 700 peut comporter deux faces opposées reliées par un bord 160 s'étendant transversalement à ces deux faces. Une feuille d'isolation électrique 550 peut être intercalée entre la plaque 700 et l'élément capacitif 300.

La substance de remplissage 400 vient notamment en contact avec le bord 160 de la plaque 700. Autrement dit, la substance de remplissage 400 vient contre l'épaisseur de la plaque 700.

La barre de connexion électrique 30 permet une connexion électrique du bloc capacitif à d'autres éléments électriques, notamment à un module électronique de puissance.

Le boîtier 20 comprend un fond et des parois latérales. Ces parois latérales peuvent présenter une légère inclinaison configurée pour favoriser un éventuel démoulage du boîtier 20 lors de sa fabrication. Les dimensions du boîtier 20 sont telles que ledit boîtier loge l'élément capacitif 300 et la substance de remplissage 400, ladite substance de remplissage 400 pouvant envelopper l'élément capacitif, notamment dans son intégralité.

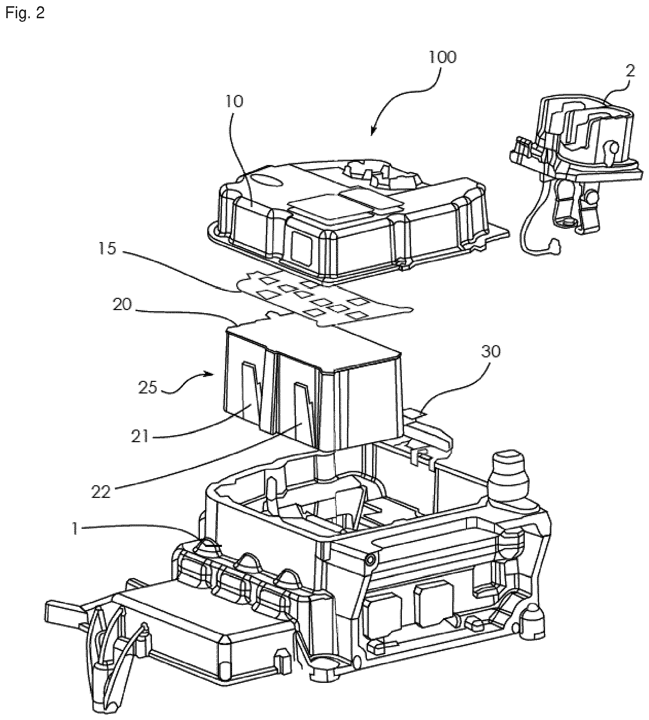

La figure 2 montre une partie d'un équipement électrique 100, telle qu'une partie d'un onduleur, en vue éclatée. Il est à noter que la présente invention s'applique également pour d'autres équipements électriques comprenant un bloc capacitif et pour lesquels le processus de montage serait similaire. L'invention s'applique par exemple dans le cas d'un chargeur électrique ou d'un convertisseur de tension continu-continu.

L'équipement électrique 100 représenté comprend un connecteur de batterie 2, par exemple pour le relier à une batterie haute tension. Le couvercle 10 est destiné à fermer le haut du châssis 1 de l'équipement électrique 100.

L'équipement électrique 100 comprend un bloc capacitif, par exemple celui illustré en figure 1. Le bloc capacitif 25 présente une enveloppe, autrement dit un boîtier 20. Le boîtier 20 est par exemple en plastique, notamment en plastique moulé.

Comme représenté sur la figure 2, de préférence, un ressort, ou plus précisément une plaque ressort 15, également désigné « spring plate » en langue anglaise, est interposée entre le bloc capacitif 25 et le couvercle 10. Une telle plaque ressort 15, une fois mise en compression par une action de fixation de l'ensemble comprenant ledit couvercle 10 et ledit bloc capacitif 25 sur le châssis, agira par réaction de sorte à exercer une pression sur le bloc capacitif 25 pour le presser contre un circuit de refroidissement intégré au châssis 1.

Le bloc capacitif 25 comprend une barre de connexion électrique 30, présentant notamment une borne positive et une borne négative destinées à être reliées aux bornes correspondantes de la batterie haute tension.

Les figures 2 à 5 montrent que, conformément à l'invention, le boîtier 20 du bloc capacitif 25 comprend au moins un premier organe de retenue, en l'espèce des clips, 21, 22 prévus, dans le mode de réalisation représenté, sur une seule face du boîtier 20. Il va de soi qu'il pourrait y avoir un seul clip ou moyen de retenue équivalent. En outre, il peut aussi y avoir deux ou davantage de clips ou organes de retenue équivalents 21, 22 répartis sur une ou plusieurs faces latérales du boîtier 20.

Le au moins un premier organe de retenue 21, 22 est destiné à coopérer avec au moins un second organe de retenue 11, 12 complémentaire aménagé sur le couvercle 10.

En particulier, comme représenté sur les figures 2 à 5, les premiers organes de retenue 21, 22 sont, selon un mode de réalisation, des clips 21, 22 présentant une branche et une excroissance terminale et ayant une souplesse adaptée pour s'engager avec les seconds organes de retenue 11, 12.

En particulier, les excroissances terminales des clips 21, 22 sont adaptées pour venir, lorsque lesdits clips sont engagés en vis-à-vis des seconds organes de retenue aménagés sur le couvercle 10, en appui contre une surface desdits seconds organes de retenue 11, 12, ladite surface formant une butée.

Par exemple, les seconds organes de retenue 11, 12 sont une ou plusieurs rainures creusées dans la surface interne de la paroi latérale du couvercle 10.

Les seconds organes de retenue 11, 12 peuvent aussi être des épaulements prévus sur la surface interne de la paroi latérale du couvercle 10.

Grâce aux premiers 21, 22 et seconds 11, 12 organes de retenue, le bloc capacitif 25 reste solidaire du couvercle 10 et ne chute pas lors du retournement de l'ensemble comprenant ledit bloc capacitif 25 et ledit couvercle 10 pendant un processus d'assemblage nécessitant un tel retournement.

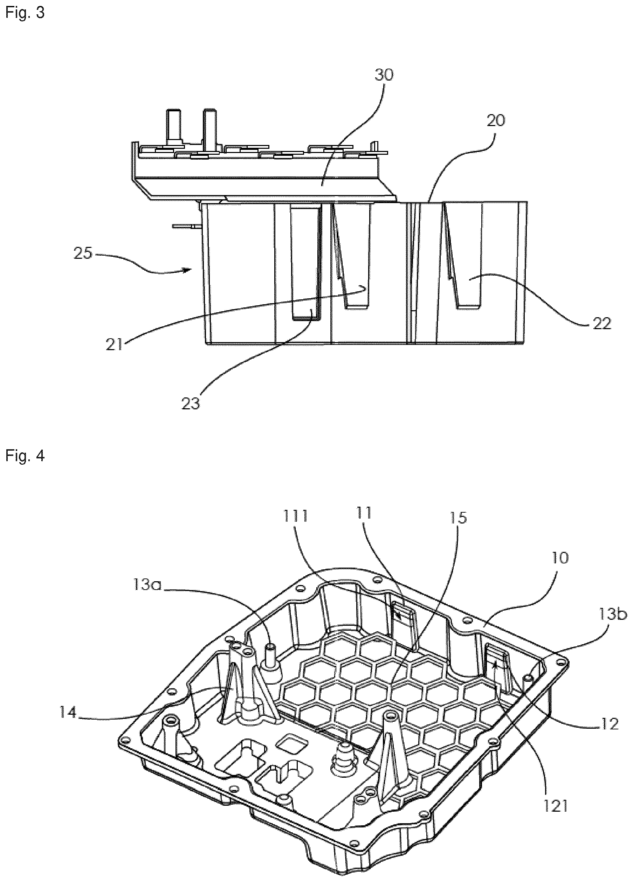

En effet, dans certaines configurations de chaîne d'assemblage, on réalise, en référence à la figure 4, un ensemble comprenant le couvercle 10 dans lequel on vient disposer le bloc capacité 20, que l'on engage dans le couvercle 10 à l'aide des plots de guidage 13a, 13b.

Le boîtier 20 du bloc capacitif 25 comprend alors des fûts 23 dans lesquels s'engagent les plots de guidage 13a, 13b, pour participer au maintien du bloc capacitif lors du retournement de l'ensemble dudit couvercle 10 et dudit bloc capacitif 25. L'engagement du plot de guidage 13a, 13b dans un fût 23 du bloc capacitif 25 participe, avec les premiers 21, 22 et seconds 11, 12 organes de retenue, à éviter le basculement du bloc capacitif 25 lors du retournement de l'ensemble comprenant ledit bloc capacitif 25 et le couvercle 10. Selon une forme de réalisation, il peut aussi n'y avoir qu'un seul plot de guidage 13a.

La figure 5 montre l'ensemble, selon une vue en perspective montrant par ailleurs la barre de connexion électrique 30 destinée à connecter le bloc capacitif 25 à un module de puissance d'un onduleur par exemple, via les connecteurs 33.

Durant le montage du bloc capacitif 25 dans le couvercle 10, les premiers organes de retenue, en l'espèce les clips 21, 22 sont engagés dans les seconds organes de retenue, en l'espèce les rainures 11, 12.

Les seconds organes de retenus 11, 12 comprennent une butée contre laquelle vient en appui les premiers organes de retenue 21, 22 lors du retournement de l'ensemble comprenant le couvercle 10 et le bloc capacitif 25, de façon à éviter la chute dudit bloc capacitif 25.

Durant le processus d'assemblage, l'ensemble comprenant le couvercle 10 et le bloc capacitif 25 est ainsi retourné et disposé sur un châssis 1. Le châssis 1 comprend, dans sa partie supérieure, un circuit de refroidissement, contre lequel se retrouve le bloc capacité 25 après retournement de l'ensemble comprenant le couvercle 10 et le bloc capacitif 25.

Selon le mode de réalisation représenté sur les figures, la plaque ressort 15 est prévue dans le couvercle 10 et se trouve légèrement comprimée par la présence du bloc capacitif 25 lors de la réalisation de l'ensemble comprenant le couvercle 10 et le bloc capacitif 25.

Dans ce cas, en référence à la figure 4, il est en outre prévu un jeu 111, 121 en vis-à-vis de la butée des seconds organes de retenue 11, 12, ledit jeu 111, 121 permettant un degré de liberté en translation du bloc capacitif 25 dans une direction opposée au côté du bloc capacitif 25 où se trouve le couvercle 10. Une fois l'ensemble comprenant le couvercle 10 et le bloc capacitif 25 disposé, après retournement, sur le châssis 1, ledit ensemble est fixé audit châssis 1, notamment par vissage au moyen de vis engagées dans les fûts de fixation 14 du couvercle 10.

Cette fixation de l'ensemble sur le châssis 1 permet d'exploiter la réaction de la plaque ressort 15 à la compression dont elle fait l'objet, en raison du vissage notamment. Grâce au jeu 111, 121 existant en vis-à-vis de la butée des seconds organes de retenue 11, 12, et permettant aux premiers organes de retenue 21, 22 de se dégager des seconds organes de retenue 11, 12, le châssis 1 presse le bloc capacitif 25 contre ladite plaque ressort 15. Le bloc capacitif 25 translate pour comprimer davantage la plaque ressort 15. Par réaction, la plaque ressort 15 presse davantage le bloc capacitif 25 contre le châssis 1 et son circuit de refroidissement, permettant une meilleure dissipation thermique de la chaleur produite par ledit bloc capacitif 25 durant son fonctionnement.

## Revendications

1. Ensemble d'un couvercle (10) et d'un bloc capacitif (25), le bloc capacitif (25) comprenant un boîtier (20) qui comprend au moins un premier organe de retenue (21, 22), le couvercle (10) comprenant au moins un second organe de retenue (11, 12) complémentaire, le au moins un second organe de retenue (11, 12) comportant une butée de retenue configurée pour recevoir une portion dudit au moins un premier organe de retenue (21, 22) lorsque le bloc capacitif (25) est engagé dans le couvercle (10), de façon à retenir le bloc capacitif (25) lors d'un retournement de l'ensemble dudit couvercle (10) et dudit bloc capacitif (25), notamment lors d'une phase d'assemblage dudit ensemble sur un châssis (1) d'un équipement électrique, le au moins un second organe de retenue (11, 12) présentant un jeu (111, 121) permettant un degré de liberté en translation du bloc capacitif (25) vis-à-vis du couvercle (10) dans une direction opposée à la butée de retenue.

2. Ensemble selon la revendication précédente, dans lequel le au moins un premier organe de retenue (21, 22) comprend au moins un clip de retenue issu de matière du boîtier (20) du bloc capacitif (25) et comprenant une excroissance configurée pour coopérer avec la butée du au moins un second organe de retenue (11, 12).

3. Ensemble selon l'une des revendications précédentes, dans lequel le boîtier (20) du bloc capacitif (25) comprend au moins un fût (23) dans lequel s'engage au moins un plot de guidage (13a, 13b), pour participer au maintien du bloc capacitif lors du retournement de l'ensemble dudit couvercle (10) et dudit bloc capacitif (25).

4. Ensemble selon l'une des revendications précédentes, dans lequel le moins un second organe de retenue (11, 12) comprend au moins une rainure aménagée dans une surface interne d'une paroi latérale du couvercle (10).

5. Ensemble selon l'une des revendications précédentes, dans lequel le au moins un second organe de retenue (11, 12) comprend au moins un épaulement aménagé dans la masse d'une surface interne d'une paroi latérale du couvercle (10).

6. Ensemble selon l'une des revendications précédentes, comprenant une plaque ressort positionnée dans le couvercle (15), le bloc capacitif (25) étant disposé en appui sur ladite plaque ressort (15).

7. Équipement électrique, notamment adapté à être mis en oeuvre dans un véhicule électrique ou hybride, comprenant un ensemble selon l'une des revendications précédentes.

8. Onduleur comprenant un châssis (1) comportant un circuit de refroidissement, comprenant un ensemble selon l'une des revendications 1 à 6 disposé d'un côté du circuit de refroidissement et, disposé de l'autre côté du circuit de refroidissement, un module électronique de puissance (5).

## Patentansprüche

1. Anordnung aus einem Deckel (10) und einem kapazitiven Block (25), wobei der kapazitive Block (25) ein Gehäuse (20) umfasst, das mindestens ein erstes Halteelement (21, 22) umfasst, wobei der Deckel (10) mindestens ein komplementäres zweites Halteelement (11, 12) umfasst, wobei das mindestens eine zweite Halteelement (11, 12) einen Halteranschlag aufweist, der konfiguriert ist, um einen Teil des mindestens einen ersten Halteelements (21, 22) aufzunehmen, wenn der kapazitive Block (25) in den Deckel (10) eingesetzt ist, um den kapazitiven Block (25) beim Umdrehen der Anordnung aus dem Deckel (10) und dem kapazitiven Block (25) zu halten, insbesondere während einer Montagephase der Anordnung auf einem Chassis (1) einer elektrischen Ausrüstung, wobei das mindestens eine zweite Halteelement (11, 12) ein Spiel (111, 121) aufweist, das einen Freiheitsgrad in der Translation des kapazitiven Blocks (25) gegenüber dem Deckel (10) in einer Richtung entgegengesetzt zum Halteranschlag ermöglicht.

2. Anordnung nach dem vorhergehenden Anspruch, wobei das mindestens eine erste Halteelement (21, 22) mindestens einen Halteclip umfasst, der aus dem Material des Gehäuses (20) des kapazitiven Blocks (25) gebildet ist und einen Vorsprung umfasst, der konfiguriert ist, um mit dem Anschlag des mindestens einen zweiten Halteelements (11, 12) zusammenzuwirken.

3. Anordnung nach einem der vorhergehenden Ansprüche, wobei das Gehäuse (20) des kapazitiven Blocks (25) mindestens eine Hülse (23) umfasst, in die mindestens ein Führungsstift (13a, 13b) eingreift, um zur Halterung des kapazitiven Blocks beim Umdrehen der Anordnung aus dem Deckel (10) und dem kapazitiven Block (25) beizutragen.

4. Anordnung nach einem der vorhergehenden Ansprüche, wobei das mindestens eine zweite Halteelement (11, 12) mindestens eine Nut umfasst, die in einer Innenfläche einer Seitenwand des Deckels (10) ausgebildet ist.

5. Anordnung nach einem der vorhergehenden Ansprüche, wobei das mindestens eine zweite Halteelement (11, 12) mindestens eine Schulter umfasst, die in der Masse einer Innenfläche einer Seitenwand des Deckels (10) ausgebildet ist.

6. Anordnung nach einem der vorhergehenden Ansprüche, umfassend eine Federplatte, die im Deckel (15) positioniert ist, wobei der kapazitive Block (25) auf der Federplatte (15) aufliegt.

7. Elektrische Ausrüstung, insbesondere geeignet zur Verwendung in einem Elektro- oder Hybridfahrzeug, umfassend eine Anordnung nach einem der vorhergehenden Ansprüche.

8. Wechselrichter, umfassend ein Chassis (1) mit einem Kühlkreislauf, umfassend eine Anordnung nach einem der Ansprüche 1 bis 6, die auf einer Seite des Kühlkreislaufs angeordnet ist, und ein elektronisches Leistungsmodul (5), das auf der anderen Seite des Kühlkreislaufs angeordnet ist.

## Claims

1. Assembly of a cover (10) and a capacitive block (25), the capacitive block (25) comprising a housing (20) which includes at least one first retaining member (21, 22), the cover (10) comprising at least one complementary second retaining member (11, 12), the at least one second retaining member (11, 12) having a retaining stop configured to receive a portion of said at least one first retaining member (21, 22) when the capacitive block (25) is engaged in the cover (10), so as to retain the capacitive block (25) during an inversion of the assembly of said cover (10) and said capacitive block (25), particularly during an assembly phase of said assembly on a chassis (1) of an electrical equipment, the at least one second retaining member (11, 12) having a clearance (111, 121) allowing a degree of freedom in translation of the capacitive block (25) with respect to the cover (10) in a direction opposite to the retaining stop.

2. Assembly according to the preceding claim, wherein the at least one first retaining member (21, 22) comprises at least one retaining clip formed from the material of the housing (20) of the capacitive block (25) and comprising a protrusion configured to cooperate with the stop of the at least one second retaining member (11, 12).

3. Assembly according to one of the preceding claims, wherein the housing (20) of the capacitive block (25) comprises at least one barrel (23) in which at least one guide pin (13a, 13b) engages, to participate in maintaining the capacitive block during the inversion of the assembly of said cover (10) and said capacitive block (25).

4. Assembly according to one of the preceding claims, wherein the at least one second retaining member (11, 12) comprises at least one groove arranged in an internal surface of a lateral wall of the cover (10).

5. Assembly according to one of the preceding claims, wherein the at least one second retaining member (11, 12) comprises at least one shoulder arranged in the mass of an internal surface of a lateral wall of the cover (10).

6. Assembly according to one of the preceding claims, comprising a spring plate positioned in the cover (15), the capacitive block (25) being disposed in support on said spring plate (15).

7. Electrical equipment, particularly adapted to be implemented in an electric or hybrid vehicle, comprising an assembly according to one of the preceding claims.

8. Inverter comprising a chassis (1) having a cooling circuit, comprising an assembly according to one of claims 1 to 6 arranged on one side of the cooling circuit and, arranged on the other side of the cooling circuit, a power electronic module (5).
